# EUROPEAN PATENT SPECIFICATION

(11) **EP 3 391 705 B1**
(45) Date of publication and mention of the grant of the patent: **20.11.2019**
(21) Application number: 16854603.4
(22) Date of filing: 19.12.2016
(51) Int. Cl.: H05B 3/34, H01L 35/32

(54) **HEATING AND COOLING ENGINE**
HEIZ- UND KÜHLMOTOR
MOTEUR DE CHAUFFAGE ET DE REFROIDISSEMENT

(30) Priority: 18.12.2015 US 201562269526 P
(43) Date of publication of application: 24.10.2018
(73) Proprietor: Magna Seating Inc., Aurora, Ontario L4G 7K1 (CA)
(72) Inventor: KOZLOWSKI, Eric, Oakland Township, MI 48363 (US); DAVIS, Jason, Commerce Township, MI 48390 (US); STEPANOV, Artur, Auburn Hills, MI 48326 (US)
(74) Representative: Glawe, Delfs, Moll
(86) International application number: PCT/US2016/067500
(87) International publication number: WO 2017/106829

(56) References cited:
- DE-A1-102012 018 387
- GB-A- 912 001
- US-A1- 2010 024 437
- US-A1- 2014 305 482

## Description

### CROSS-REFERENCE TO RELATED APPLICATIONS

This application claims priority to United States Provisional Application No. 62/269,526, filed on December 18, 2015.

### BACKGROUND OF THE INVENTION

### 1. Field of the Invention

The present invention relates to a heating and cooling engine. More particularly, the invention relates to a heating and cooling mat for rapidly heating and cooling the surface of a seat assembly for seat occupant comfort.

### 2. Description of Related Art

Automotive vehicles include one or more seat assemblies having a seat cushion and a seat back for supporting a passenger or occupant above a vehicle floor. The seat assembly is commonly mounted to the vehicle floor by a riser assembly. The seat back is typically operatively coupled to the seat cushion by a recliner assembly for providing selective pivotal adjustment of the seal back relative to the seat cushion. Each of the seat cushion and seat back commonly comprise a base foam pad supported by a rigid frame structure and encased in a fabric trim cover of fabric, leather, and/or vinyl. The base foam pad provides the firm support and durability to the seat cushion and scat back. A trim padding is also commonly disposed between the base foam pad and the trim cover to provide a softer surface for seat occupant comfort.

It is commonly known to provide seat assemblies with heating and/or cooling mechanisms for selectively heating and cooling the surface of the seat for seat occupant comfort. These known heating and cooling mechanisms are typically independent mechanisms. For example, it is common to provide an electric wire heating pad between the foam pad and trim cover of the seat cushion or seat back which is electrically actuated by the power from the vehicle battery to electrically charge the electric wire heating pad and provide heat to the surface of the seat cushion or seat back. It is also known to provide fans and air ducts to force cool air through the foam pad and trim cover and provide cool air to the surface of the seat cushion or seat back. It is also known to provide fans and ducts to draw warm, moist air away from the seating surface to provide a gradual cooling effect.

However, current heating and cooling mechanisms require a fair amount of time and power to generate sufficient heat or cool air to affect the temperature of the seat assembly and the desired comfort for the seat occupant.

It is desirable, therefore, to provide a heating and cooling engine which can rapidly or almost instantly provide heating or cooling to the surface of the seat assembly.

A heating and cooling engine according to the preamble of claim 1 is disclosed in GB 912 001 A. An electric power generating thermoelectric module having similar features as disclosed in GB 912 001 A is described in US 2010/024437 A1.

### SUMMARY OF THE INVENTION

A heating and cooling engine is provided comprising a center isolator for isolating electric and thermal energy. The center isolator has a top surface and an opposite bottom surface. A plurality of spaced apart thermoelectric elements are supported by the center isolator between the top and bottom surface. The thermoelectric elements have a top side and an opposite bottom side. A first plurality of electrically and thermally conductive buss bars are secured to the top surface of the center isolator and electrically connected to the top side of at least a pair of the thermoelectric elements. A second plurality of electrically and thermally conductive buss bars are secured to the bottom surface of the center isolator and electrically connected to the bottom side of at least a pair of the thermoelectric elements wherein thermal energy is generated to the first and second plurality of buss bars by the thermoelectric elements. The thermoelectric elements is a Peltier device and the center isolator is a layer of silicone.

### BRIEF DESCRIPTION OF THE DRAWINGS

Advantages of the present invention will be readily appreciated as the same becomes better understood by reference to the following detailed description when considered in connection with the accompanying drawings wherein:
Figure 1 is a top view of a plurality of buss bars;
Figure 2 is a top view of a plurality of alternative buss bars;
Figure 3 is perspective view of a plurality of thermoelectric elements;
Figure 4 is a perspective view of a silicone center isolator;
Figure 5 is a tope view of a wool center isolator, which is not covered by the claimed invention;
Figure 6 is a perspective view of a bottom plate;
Figure 7 is a perspective view of the bottom plate supporting a plurality of spaced apart buss bars;
Figure 8 is a perspective view of the bottom plate supporting the buss bars and center isolator;
Figure 9 is a perspective view of applying solder to the buss bars of Figure 8;
Figure 10 is a perspective view of a plurality of spaced apart thermoelectric elements seated in the center isolator;
Figure 11 is a perspective view of applying solder to the thermoelectric elements;
Figure 12 is a perspective view of a plurality of buss bars seated against the thermoelectric elements;
Figure 13 is a bottom perspective view of an upper plate;
Figure 14 is a perspective view of the upper plate clamped to the lower plate;
Figure 15 is a perspective view of a heating and cooling mat;
Figure 16 is a perspective view of an alternative heating and cooling mat;
Figure 17 is a cross-sectional view of the heating and cooling mat of Figure 15; and
Figure 18 is a fragmentary perspective view of a seat assembly using the heating and cooling mat.

### DETAILED DESCRIPTION OF THE EMBODIMENTS

Referring to the Figures, wherein like numerals indicate like or corresponding parts throughout the several views, a heating and cooling engine, or mat, according to a preferred embodiment of the invention for use in providing rapid heating and cooling to a surface area includes a plurality of thermoelectric elements for creating heating and cooling energy; a plurality of buss bars for the heating and cooling energy from the thermoelectric elements; a center isolator to separate the heating and cooling energy produced from the thermoelectric elements and for providing electrical and thermal isolation; and a solder material for mechanically bonding the thermoelectric elements and isolator between the buss bars and create an electric connection therebetween.

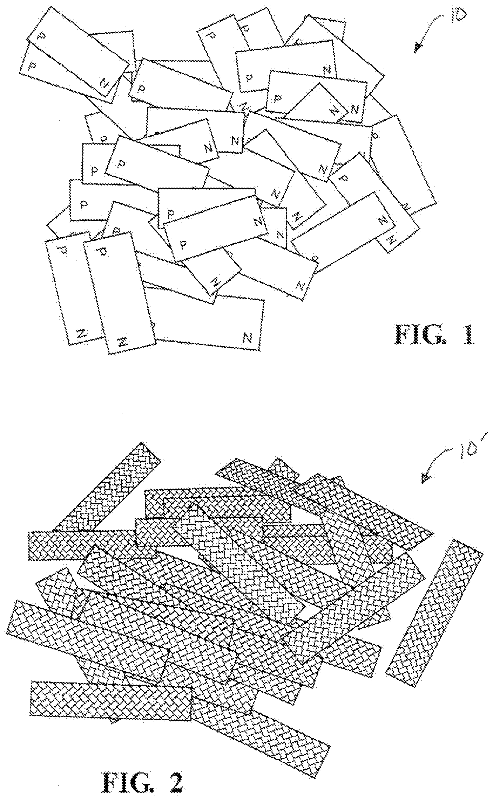

More specifically, referring to Figures 1 and 2, the buss bars are generally shown at 10 and comprises generally thin square or rectangular shaped bars constructed of any electrically and thermally conductive materials including but not limited to copper or aluminum. In order to maximize the thermal energy transfer from the thermoelectric elements to the surface area, the size of the buss bars 10 preferably make up seventy (70) percent or more of the total surface area of the heating and cooling mat. Further, it is also preferable that the electrically and thermally conductive material of the buss bars 10 is flexible and allowed to be contoured to the shape of the surface area of use. Such suitable material of copper or aluminum may include foil or thin sheets of material forming the buss bars as shown at 10 in Figure 1. Alternatively, small diameter, elongated woven or braided wire of copper or aluminum may be utilized forming a buss bar as shown at 10' in Figure 2.

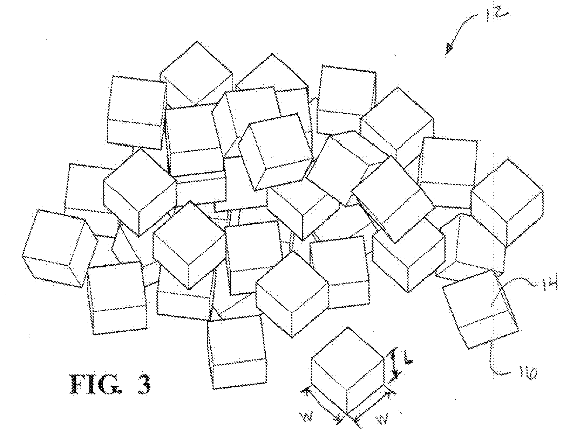

Referring to Figure 3, the thermoelectric elements are shown at 12 forming a plurality of cube shaped elements. The elements 12 use the Peltier effect to create cold on one side, or tope side 14, of the element and heat on the opposite side, or bottom side 16, of the element 12 when electrically activated. That is, positive (P) and negative (N) elements 12 are arranged in alternating order in the mat to achieve the Peltier effect of cooling on one side and heating on the other as will be further described hereinbelow. The dimensions of each element 12 may vary in size and shape, but the optimized dimensions are defined by a cuboid of the following ratio: 0.004m<W²/L<0.005m. Further, many materials are suitable for the elements 12, but the preferred material is a Bismuth Telluride alloy that is doped into both N and P varieties. Additionally, the elements 12 are preferable plated in nickel and/or tin to aid in thermal conductivity connecting with the buss bars 10.

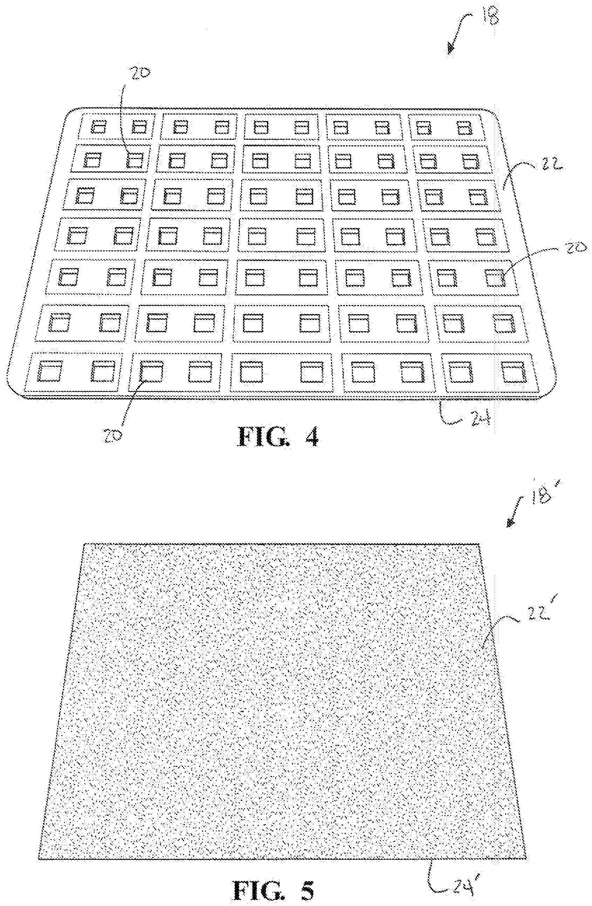

Referring to Figures 4 and 5, the center isolator includes a planar panel of cast silicone as shown at 18 in Figure 4 or alternatively, and not covered by the claimed invention, a planar panel of wool as shown at 18' in Figure 5. Aramids or other suitable high temperature isolator materials are also possible alternatives which are not covered by the claimed invention. The silicone isolator 18 of Figure 4 includes a plurality of spaced apart openings 20 extending between opposite top and bottom surface 22, 24 thereof for receiving and supporting the thermoelectric elements 12 therein. The buss bars 10 are arranged on both the top and bottom surface 22, 24. The purpose of the center isolator 18, 18' is to electrically isolate the plurality of buss bars 10 from shorting and so that heat will not thermally back-flow from the top and bottom of the mat. The center isolator 18, 18' of silicone (or wool, which is not covered by the claimed invention) is very flexible to allow contouring to the surface area and has high temperature resistance to handle in-place re-flow soldering methods as will be further described.

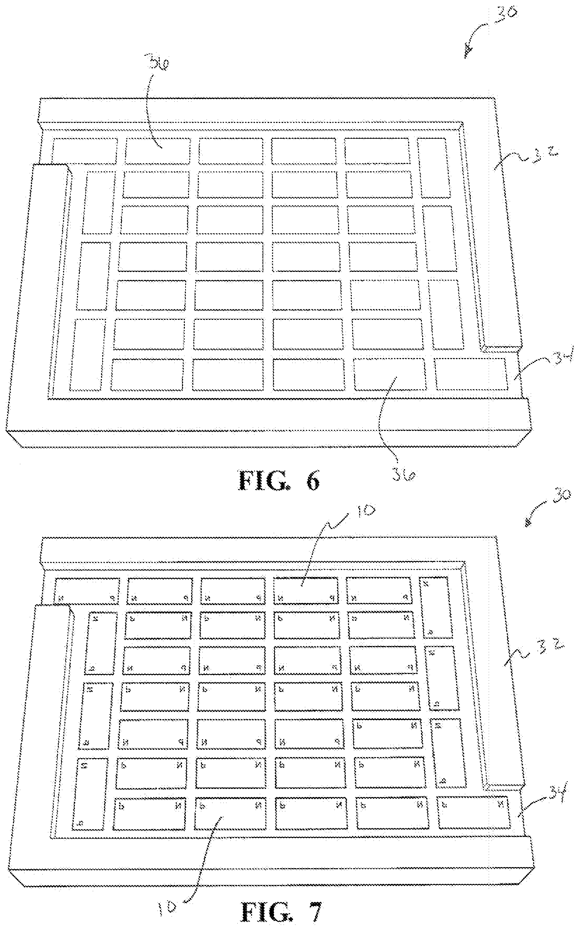

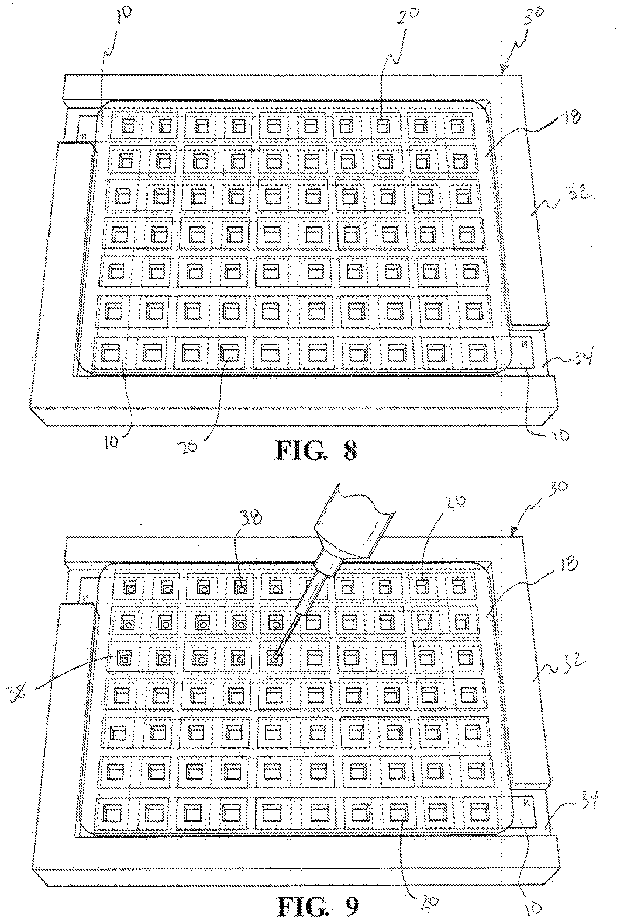

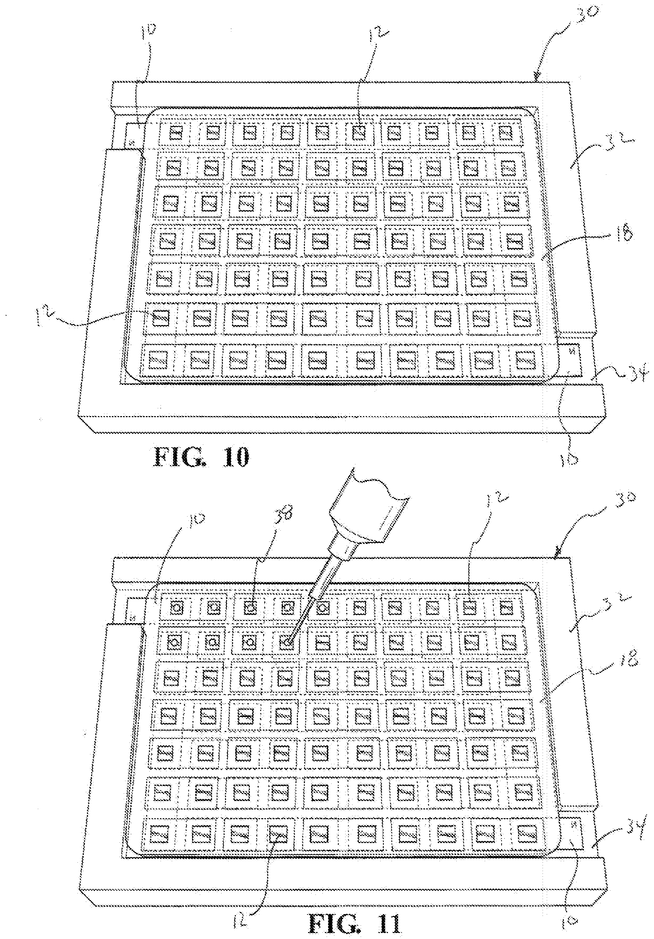

Referring to Figures 6-14, the apparatus and method of manufacturing and assembling the heating and cooling engine, or mat, is shown. First, Figure 6 shows a bottom plate 30 having a peripheral edge 32 defining a bottom cavity 34. A plurality of spaced apart and recessed locators 36 are formed in the bottom cavity 34 for receiving, arranging, and retaining the buss bars 10. Figure 7 shows a buss bar 10 seated in each of the recessed locators 36 in the bottom plate 30. Referring to Figure 8, the center isolator 18 is seated in the bottom cavity 34 on top of the plurality of buss bars 10 wherein each opening 20 in the isolator 18 exposes a portion of each respective buss bar 10 beneath the isolator 18. In Figure 9, a dollup or small amount of solder material 38, such as that available from Kester Inc., is applied to the surface of each buss bar 10 exposed by each opening 20. Referring to Figures 10 and 11, the bottom side 16 of a thermoelectric element 12 is placed in each opening 20 of the isolator 18 on top of the buss bar 10 and in contact with the solder material 38. As shown in phantom in Figure 10, each buss bar 10 supports and interconnects two adjacent thermoelectric elements 12. A second dollup or small amount of solder material 38 is then applied to the top side 14 of the thermoelectric element 12.

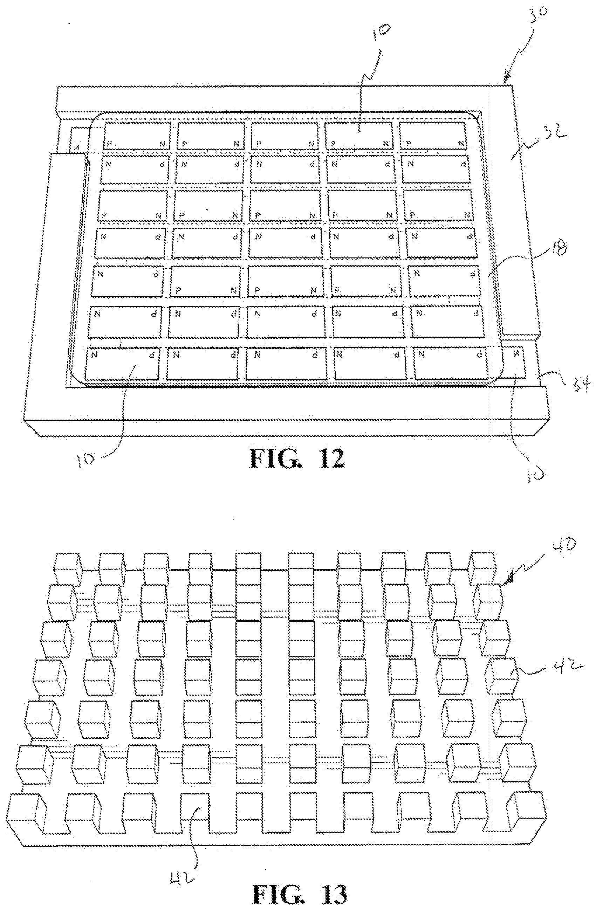

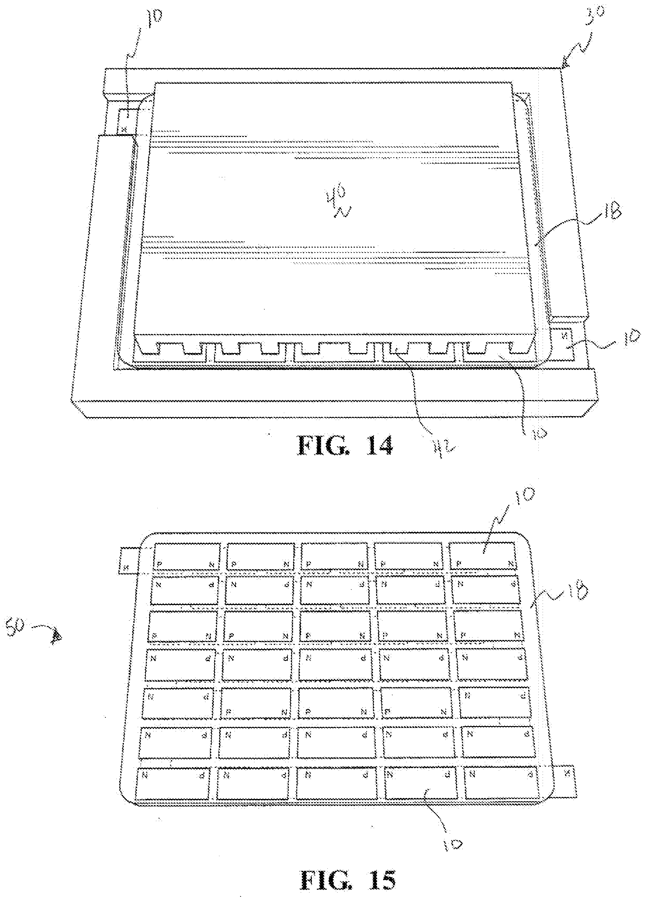

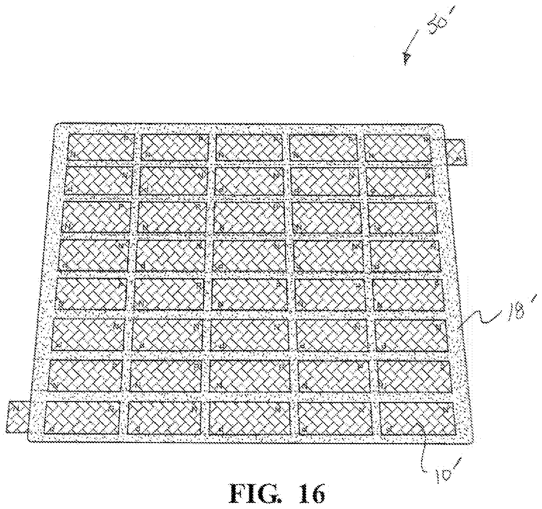

Referring to Figure 12, another plurality of buss bars 10 is placed in contact with the second amount of solder material and seated against the top side 14 of the thermoelectric elements 12 is an arrangement offset by one opening 20 to the bottom side 16 of each element 12. In Figure 13, an upper plate 40 is shown having a plurality of equally spaced apart raised solder pads 42 corresponding in spacing to each of the openings 20 in the isolator 18. The upper plate 40 is pressed against the second plurality of buss bars 10 such that the solder pads 42 are aligned with the openings 20 in the isolator and therefore with each thermoelectric element 12 seated therein as shown in Figure 14. The solder material 38 is optimized for re-flow soldering techniques and mechanically bonds the entire assembly together to form the heating and cooling engine, or mat, as shown at 50 in Figure 15. The mat 50 of Figure 15 includes copper buss bars 10 and a silicon isolator. Figure 16 discloses a similar mat 50' with the alternative braided wire buss bars 10' and wool isolator 18' which is not covered by the claimed invention.

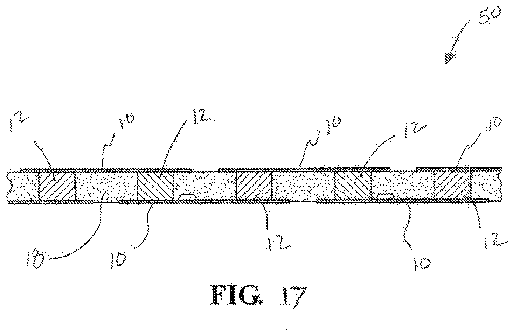

Referring to Figure 17, a cross-section view of the heating and cooling mat 50 is shown wherein the thermoelectric elements 12 are spaced apart and seated in the openings 20 of the center isolator 18. The solder material 38 electrically bonds each of the first plurality of buzz bar 10 to the top side 14 of a pair of spaced apart adjacent thermoelectric elements 12 and bonds each of the second plurality of buss bars 10 to the bottom side 16 of a pair of spaced apart adjacent thermoelectric elements 12, however, in an alternative pattern spaced or offset one opening 20 apart from the top side 14.

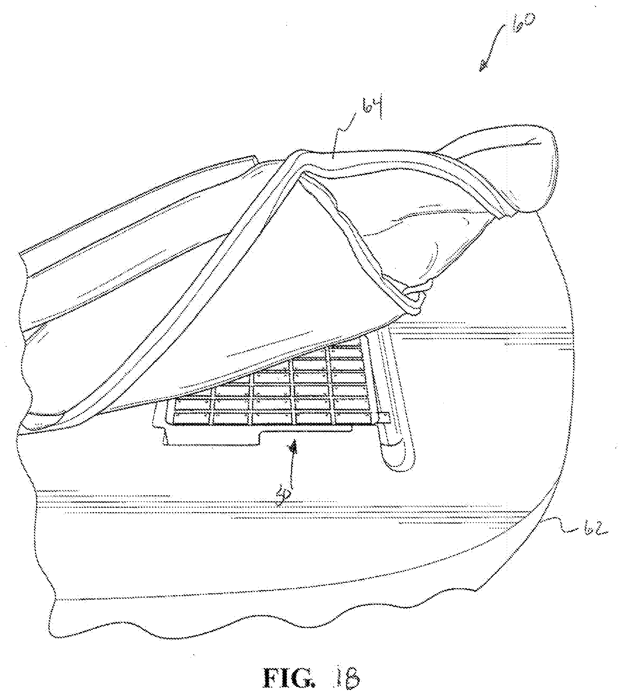

In use, in the automotive seating industry, as one example, a seat assembly generally includes a horizontal seat cushion for supporting a seat occupant within the vehicle as is commonly known in the art and shown at 60 in Figure 18. The seat cushion commonly includes a molded resilient cellular foam pad 62 encased in a trim cover 64, commonly of cloth, vinyl, or leather. The foam pad 62 provides the resilient support to the seat occupant. However, the foam pad 62 currently has a very low thermal conductivity of approximately 0.043 W/m-K, and as such, heat can build up between the seat occupant and foam pad 62. It is commonly known to provide a heating or cooling mechanism, such as an electric heating pad, in the seat assembly for providing occupant comfort. However, the foam pad 62 acts as an insulator, and therefore, the desired heating and cooling effects take considerable time to be felt by the user. Further, the power levels of the heating and cooling mechanisms have to be substantial to overcome the insulating effects of the foam pad. The present invention heating and cooling mat 50 may be seated between the foam pad 62 and trim cover 64 of the seat assembly to increase the heating and cooling effects and reduce the time to be felt by the user while minimizing power usage. The mat 50 is also thin, flexible and may be used in a variety of sizes or configurations to obtain optimum efficiency and maximize the heating and cooling effect while maintain comfort to the occupant.

It should be appreciated that the heating and cooling engine, or mat, may be used in seat cushions, seat backs, furniture, bedding or other applications where efficient heating, cooling or power generation is desired.

The invention has been described in an illustrative manner, and it is to be understood that the terminology, which has been used, is intended to be in the nature of words of description rather than of limitation. Many modifications and variations of the present invention are possible in light of the above teachings. It is, therefore, to be understood that within the scope of the appended claims, the invention may be practiced other than as specifically described.

## Claims

1. A heating and cooling engine comprising:
a center isolator (8) for isolating electric and thermal energy, said center isolator (8) having a top surface (22) and an opposite bottom surface (24);
a plurality of spaced apart thermoelectric elements (12) supported by said center isolator (8) between said top and bottom surface (22, 24); said thermoelectric elements (12) having a top side (14) and an opposite bottom side (16);
a first plurality of electrically and thermally conductive buss bars (10) secured to said top surface (22) of said center isolator (8) and electrically connected to said top side (14) of at least a pair of said thermoelectric elements (12); and
a second plurality of electrically and thermally conductive buss bars (10) secured to said bottom surface (24) of said center isolator (8) and electrically connected to said bottom side (16) of at least a pair of said thermoelectric elements (12) wherein thermal energy is generated to said first and second plurality of buss bars (10) by said thermoelectric elements (12);
**characterized in that** said thermoelectric elements (12) is a Peltier device and said center isolator (8) is a layer of silicone.

2. The heating and cooling engine as set forth in claim 1 wherein said thermoelectric elements (12) are soldered between said first and second plurality of buss bars (10).

3. The heating and cooling engine as set forth in claim 2 wherein said first plurality of buss bars (10) are arranged and offset by at least one thermoelectric element (12) relative to said second plurality of buss bars (10).

4. The heating and cooling engine as set forth in claim 3 wherein the center isolator (8) includes a plurality of spaced apart openings (20) extending between said top and bottom surface (22, 24).

5. The heating and cooling engine as set forth in claim 4 wherein one of said thermoelectric elements (12) is recessed in each of said openings (20) of said center isolator (8).

6. The heating and cooling engine as set forth in claim 1 wherein said buss bars (10) are sheets of copper or aluminum.

7. The heating and cooling engine as set forth in claim 1 wherein said buss bars (10) are comprised of braided wire.

## Patentansprüche

1. Heiz- und Kühlmotor, der Folgendes umfasst:
einen mittleren Isolator (8) zum Isolieren von elektrischer und Wärmeenergie, wobei der mittlere Isolator (8) eine obere Fläche (22) und eine gegenüberliegende untere Fläche (24) aufweist;
eine Vielzahl von beabstandeten thermoelektrischen Elementen (12), die vom mittleren Isolator (8) zwischen der oberen und der unteren Fläche (22, 24) gestützt werden; wobei die thermoelektrischen Elemente (12) eine obere Seite (14) und eine gegenüberliegende untere Seite (16) aufweisen;
eine erste Vielzahl von elektrisch und wärmeleitfähigen Sammelschienen (10), die an der oberen Fläche (22) des mittleren Isolators (8) befestigt und mit der oberen Seite (14) von mindestens einem Paar von thermoelektrischen Elementen (12) elektrisch verbunden sind; und
eine zweite Vielzahl von elektrisch und wärmeleitfähigen Sammelschienen (10), die an der unteren Fläche (24) des mittleren Isolators (8) befestigt und mit der unteren Seite (16) von mindestens einem Paar von thermoelektrischen Elementen (12) elektrisch verbunden sind, wobei Wärmeenergie zur ersten und zur zweiten Vielzahl von Sammelschienen (10) von den thermoelektrischen Elementen (12) erzeugt wird;
**dadurch gekennzeichnet, dass** die thermoelektrischen Elemente (12) eine Peltiervorrichtung ist und der mittlere Isolator (8) eine Siliziumschicht ist.

2. Heiz- und Kühlmotor nach Anspruch 1, wobei die thermoelektrischen Elemente (12) zwischen der ersten und der zweiten Vielzahl von Sammelschienen (10) gelötet sind.

3. Heiz- und Kühlmotor nach Anspruch 2, wobei die erste Vielzahl von Sammelschienen (10) relativ zur zweiten Vielzahl von Sammelschienen (10) angeordnet und um mindestens ein thermoelektrisches Element (12) versetzt sind.

4. Heiz- und Kühlmotor nach Anspruch 3, wobei der mittlere Isolator (8) eine Vielzahl von beabstandeten Öffnungen (20) umfasst, die sich zwischen der oberen und der unteren Fläche (22, 24) erstrecken.

5. Heiz- und Kühlmotor nach Anspruch 4, wobei eines der thermoelektrischen Elemente (12) in jede der Öffnungen (20) des mittleren Isolators (8) eingelassen ist.

6. Heiz- und Kühlmotor nach Anspruch 1, wobei die Sammelschienen (10) Bleche aus Kupfer oder Aluminium sind.

7. Heiz- und Kühlmotor nach Anspruch 1, wobei die Sammelschienen (10) aus geflochtenem Draht bestehen.

## Revendications

1. Moteur de chauffage et de refroidissement comprenant
un isolateur central (8) pour isoler de l'énergie électrique et de l'énergie thermique, ledit isolateur central (8) ayant une surface de sommet (22) et une surface de fond (24) opposées ;
une pluralité d'éléments thermoélectriques espacés (12) supportés par ledit isolateur central (8) entre ladite surface de sommet et ladite surface de fond (22, 24), lesdits éléments thermoélectriques (12) ayant un côté de sommet (14) et un côté de fond (16) opposés ;
une première pluralité de barres de bus (10) électriquement et thermiquement conductrices fixées sur ladite surface de sommet (22) dudit isolateur central (8) et connectées électriquement audit côté de sommet (14) d'une paire au moins desdits éléments thermoélectriques (12) ; et
une seconde pluralité de barres de bus (10) électriquement et thermiquement conductrices fixées sur ladite surface de fond (24) dudit isolateur central (8) et connectées électriquement audit côté de fond (16) d'une paire au moins desdits éléments thermoélectriques (12), dans lequel une énergie thermique est générée vers ladite première et ladite seconde pluralité de barres de bus (10) par lesdits éléments thermoélectriques (12) ;
**caractérisé en ce que** lesdits éléments thermoélectriques (12) forme un dispositif de Peltier et ledit isolateur central (8) est une couche de silicone.

2. Moteur de chauffage et de refroidissement selon la revendication 1, dans lequel lesdits éléments thermoélectriques (12) sont soudés entre ladite première et ladite seconde pluralité de barres de bus (10).

3. Moteur de chauffage et de refroidissement selon la revendication 2, dans lequel ladite première pluralité de barres de bus (10) sont agencées de façon décalée à raison d'au moins un élément thermoélectrique (12) par rapport à ladite seconde pluralité de barres de bus (10).

4. Moteur de chauffage et de refroidissement selon la revendication 3, dans lequel l'isolateur central (8) inclut une pluralité d'ouvertures espacées (20) s'étendant entre ladite surface de sommet et ladite surface de fond (22, 24).

5. Moteur de chauffage et de refroidissement selon la revendication 4, dans lequel l'un desdits éléments thermoélectriques (12) est renfoncé dans chacune desdites ouvertures (20) dudit isolateur central (8).

6. Moteur de chauffage et de refroidissement selon la revendication 1, dans lequel lesdites barres de bus (10) sont des tôles en cuivre ou en aluminium.

7. Moteur de chauffage et de refroidissement selon la revendication 1, dans lequel lesdites barres de bus (10) sont constituées par des fils tressés.
